(19) **Europäisches Patentamt**

**European Patent Office**

**Office européen des brevets**

(11) **EP 1 015 895 B1**

(12) **EUROPÄISCHE PATENTSCHRIFT**

(45) Veröffentlichungstag und Bekanntmachung des Hinweises auf die Patenterteilung:
**11.07.2001 Patentblatt 2001/28**

(21) Anmeldenummer: **98941207.7**

(22) Anmeldetag: **14.09.1998**

(51) Int Cl.[7]: **G01R 1/18**, G01R 15/06

(86) Internationale Anmeldenummer:
**PCT/CH98/00391**

(87) Internationale Veröffentlichungsnummer:
**WO 99/14604 (25.03.1999 Gazette 1999/12)**

(54) **SPANNUNGSTEILER**

VOLTAGE DIVIDER

DIVISEUR DE TENSION

(84) Benannte Vertragsstaaten:
**BE CH DE ES FI FR IT LI SE**

(30) Priorität: **16.09.1997 CH 218397**

(43) Veröffentlichungstag der Anmeldung:
**05.07.2000 Patentblatt 2000/27**

(73) Patentinhaber: **Trench Switzerland AG**
**4052 Basel (CH)**

(72) Erfinder:
• **MINKNER, Ruthard**
**CH-4148 Pfeffingen (CH)**
• **SCHMID, Joachim**
**D-79588 Efringen-Kirchen (DE)**

(74) Vertreter: **Bollhalder, Renato et al**
**A. Braun**
**Braun Héritier Eschmann AG**
**Patentanwälte VSP**
**Holbeinstrasse 36-38**
**4051 Basel (CH)**

(56) Entgegenhaltungen:
**EP-A- 0 510 427        DE-A- 3 435 418**
**DE-A- 3 714 945        DE-A- 19 508 582**
**GB-A- 2 044 469**

• **NAIDU ET AL.: "THE STRAY-CAPACITANCE EQUIVALENT CIRCUIT..." IEEE TRANSACTIONS ON INSTRUMENTATION AND MEASUREMENT., Bd. IM-34, Nr. 3, September 1985, Seiten 393-398, XP002072285 NEW YORK US**

**Beschreibung**

Die Erfindung betrifft einen Spannungsteiler für die Messung der Primärspannung $U_p$ zwischen Phase und Erde oder zwischen Phase und Nulleiter in Ein-, Zwei- und Dreiphasensystemen, wie er im Oberbegriff des unabhängigen Patentanspruchs 1 definiert ist.

Beispielsweise in Mittel- und Hochspannungsanlagen werden Spannungswandler dazu benutzt, eine hohe Primärspannung $U_p$ mittels eines Transformators in eine vielfach niedrigere Sekundärspannung $U_S$ umzuwandeln. Diese Spannungswandler werden heute im allgemeinen nach der IEC Spannungswandler-Norm IEC 60044-2 (1997), unter Berücksichtigung der zusätzlich geltenden Länderstandards, ausgelegt und haben je nach Anforderungen des Benutzers eine Ausgangsspannung von

$$\frac{100}{\sqrt{3}} \text{ V}$$

oder 100 V und je nach Art der eingesetzten Schutzrelais, Messgeräte etc. am Sekundärkreis angeschlossene Bürden von 0,05 VA bis 10 VA.

Durch das Aufkommen von auf Mikroprozessortechnologie basierenden neuen Schutzsystemen, Zählern und Messgeräten ist der Leistungsbedarf drastisch zurückgegangen, so dass auch die hierfür verwendeten Spannungswandler für diesen sehr geringen Leistungsbedarf ausgelegt werden können. Sie werden deshalb auch als Kleinsignal-Spannungswandler bezeichnet. Die heute üblichen elektronischen Systeme verarbeiten eine maximale Eingangsspannung von $\pm$ 10 V. Dies entspricht bei einem Spannungsfaktor von 2,0 einer Sekundärspannung

$$U_{Seff} = \pm \ \frac{10 \ V}{2,0\sqrt{2}} \approx \pm \ 3,5 \ V.$$

Bei einer erforderlichen Leistung von $P_S$ = 0,01 mW ist der Eingangswiderstand

$$R_E = \frac{U_{Seff}^{\ 2}}{P_S} = \frac{\left(\frac{10V}{2,0\sqrt{2}}\right)^2}{0,01mW} \approx 1,25 \ M\Omega.$$

Der geringe Leistungsbedarf bedeutet also, dass die Eingangswiderstände der Schutzsysteme, Zähler und Messgeräte sehr hochohmig ausgeführt werden und somit gegen Einkopplungen von externen Störungen empfindlich sind.

Für die Messung der Spannung werden neben magnetischen Spannungswandlern auch Spannungsteiler, z. B. kapazitive Teiler (C-Teiler), ohmsche Teiler (R-Teiler), kompensierte ohmsche Teiler (kompensierte R-Teiler) und ohmsche-kapazitive Teiler (RC-Teiler) als Messumformer eingesetzt.

C-Teiler können nur Wechselspannung messen und je nach Grösse der Kapazität C und der Belastung durch ein Messgerät liegt der messbare Frequenzbereich zwischen 20 Hz bis 1 MHz oder sogar höher. R-Teiler und kompensierte R-Teiler sind in der Lage, die Spannung im Frequenzbereich von 0 Hz (Gleichspannung) bis ca. 100 kHz zu messen und sind daher den heutigen induktiven Spannungswandlern überlegen. RC-Teiler können die Spannung im Frequenzbereich von 0 Hz bis 1 MHz oder sogar höher messen.

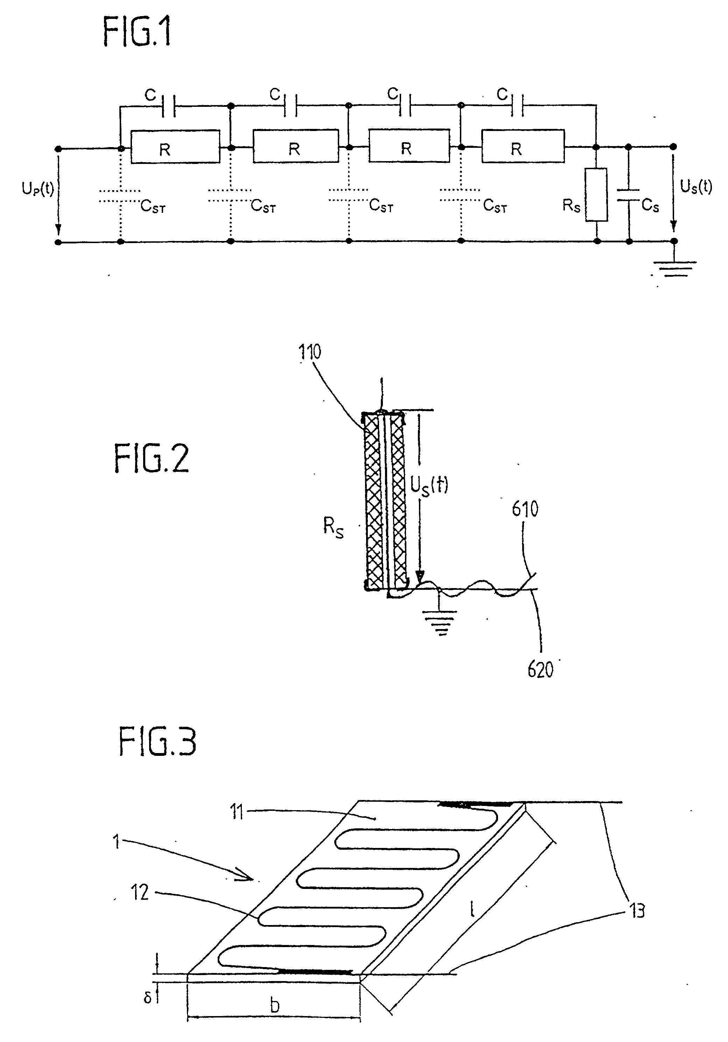

Der Trend bei Mittelspannungs- und Hochspannungsanlagen geht in Richtung Universalwandler, d.h. der Wandler muss für die Standardaufgaben Zählung, Messung und Schutz geeignet sein und in Zukunft auch diagnostische Aufgaben, wie die Messung von Teilentladungen, übernehmen können. Dies erfordert Messungen der Primärspannung für Frequenzen bis ca. 2 MHz, was mit einem RC-Teiler möglich ist. Es kann zweckmässig sein, am Ausgang des Teilers ein oder zwei Filter anzuschalten, um die Standardfunktionen des Spannungsteilers für Zählung, Messung und Schutz von den Diagnosefunktionen zu trennen. Das Ersatzschaltbild eines RC-Teilers ist in Fig. 1 dargestellt.

In Fig. 1 liegt links am Eingang des Spannungsteilers die Primärspannung $U_p(t)$, während man rechts am Ausgang die Sekundärspannung $U_S(t)$ erhält. Der Spannungsteiler umfasst vier in Serie geschaltete ohmsche Primärwiderstände R und zu jedem Primärwiderstand parallelgeschaltet eine Längskapazität C. Darüber hinaus sind zwischen den Primärwiderständen R und der Erde Streukapazitäten $C_{ST}$ vorhanden. Der Primärteil des Spannungsteilers besteht aus den Primärwiderständen R und den Längskapazitäten C und der Sekundärteil des Spannungsteilers aus dem Sekundärwiderstand $R_S$ und der Sekundärkapazität $C_S$. Die Längskapazitäten C und die Sekundärkapazität $C_S$ liegen in Form von Kondensatoren vor, während sich die Streuersatzkapazitäten $C_{ST}$ aus der Anordnung der übrigen Elemente ergeben.

Für die bisher bekannten Spannungsteiler mit einem Ersatzschaltbild gemäss Fig. 1 wurden als Widerstände R Draht-, Schicht-, Masse- und Dickschichtwiderstände eingesetzt. Der Drahtwiderstand ist bezüglich der Stabilität den Schicht-, Masse- und Dickschichtwiderständen überlegen. Aber der Drahtwiderstand hat die Nachteile, dass er sehr teuer ist und eine hohe Eigeninduktivität besitzt. Für industrielle Anwendungen wird mehr und mehr die Dickschichttechnologie eingesetzt.

In der DE-A-195 08 582 ist ein Spannungswandler mit einem Ohmschen Spannungsteiler mit einem einen Primärwiderstand aufweisenden Primärteil, einem einen Sekundärwiderstand aufweisenden Sekundärteil und zwei an den Sekundärteil angeschlossenen Messleitungen beschrieben. Der einzige Primärwiderstand ist zickzackförmig ausgebildet, wobei aber nicht erläutert wird, was damit bezweckt wird. Zur kapazitiven Potentialsteuerung sind Abschirmelektroden vorhanden, durch welche eine gewisse Abschirmung gegen die Einkopplung von Störspannungen erreicht wird. Da die Abschirmelektroden direkt mit dem Primärwiderstand verbunden sind, werden aber, insbesondere über die Abschirmelektrode am ersten Potentialausgleich, kapazitive Störspannungen eingekoppelt. Ausserdem bilden die im Ohmschen Spannungsteiler vorhandenen Leiter eine Schleife, in der durch die vorhandenen Magnetfelder des Leiters, an dem die Spannung gemessen werden soll, eine Störspannung induziert wird. Ein Hinweis auf die Verhinderung von induktiv eingekoppelten Störspannungen, verursacht durch externe Magnetfelder, fehlt. Der unabhängige, Patentanspruch 1 ist gegenüber diesem Spannungswandler abgegrenzt.

In der DE-A-34 35 418 ist ein Gleichspannungsteiler für Hochspannungs-Gleichstrom-Übertragungs-Anlagen offenbart, der mit seinem Potentialabgriff verbundene Messleitungen aufweist, die verdrillt und abgeschirmt sind. Die Abschirmung und Anordnung der Messleitungen sind so, dass in erster Linie ein Schutz gegen das Magnetfeld eines durch einen Shunt fliessenden Laststroms gewährleistet ist, was sich durch die bekannte Lage des Shunts leicht erreichen lässt. Der Gleichspannungsteiler ist aber derart aufgebaut, dass in den Schleifen der RC-Stufen durch externe Magnetfelder Störspannungen induziert werden können. Ausserdem können auf der Niederspannungsseite Störspannungen und Störströme durch elektrische und magnetische Felder erzeugt werden. Durch die Störspannungen und Störströme wird die Messung der Primärspannung verfälscht.

In der DE-A-37 14 945 ist ein freqenzunabhängiger RC-Teiler mit einer Anzahl in Serie geschalteten Einzelwiderständen mit parallel geschalteten Kondensatoren beschrieben, der durch die Anordnung in einem Hochspannungsgenerator zumindest teilweise gegen die Einkopplung von kapazitiven Störspannungen geschützt ist. Über die Stirnflächen eines ersten Teilwiderstands sind aber Einstreuungen durch elektrische Felder möglich. Ausserdem ist ein zweiter Teilwiderstand in Leiterschleifen angeordnet, in denen durch externe Magnetfelder Störspannungen erzeugt werden können. Durch den Einbau von Zusatzkapazitäten wird eine gewünschte Spannungs-Übergangs- oder Übertragungsfunktion erzeugt.

Untersuchungen an Spannungsteilern in den letzten Jahren zeigten folgende Hauptschwachstellen auf:

a) Beeinflussung der Spannung im sekundären Messkreis durch sich ändernde magnetische Felder (induktive Einkopplung).

b) Veränderung des Übersetzungsverhältnisses bei Temperaturunterschieden im Spannungsteiler infolge Erwärmung durch die Verlustleistung der ohmschen Widerstände R des Teilers.

c) Unbefriedigendes transientes Verhalten des reinen C-Teilers für Schutz- und Messzwecke.

d) Bleibende Veränderung des Übersetzungsverhältnisses beim Einsatz von Dickschicht-, Schicht- und Massewiderständen durch schnelle Änderung der Primärspannung, wie sie bei Rückzündungen in Vakuumschaltern auftritt.

e) Langsame Zerstörung des Aktivteils von Schichtwiderständen durch hohe elektrische Feldstärken.

f) Beeinflussung des Spannungsteilers mit Fehlmessung am Sekundärteil durch elektrische Wechselfelder (kapazitive Kopplung).

Die Beurteilung der angegebenen Schwachstellen gibt folgendes Bild:
a), d), e) und f) können unter dem Begriff EMV zusammengefasst werden. Für Spannungen bis 36 kV ist f) durch eine gute metallische Abschirmung als gelöst anzusehen. c) ist rein physikalisch bedingt und kann nur durch einen R-Teiler, kompensierten R-Teiler oder RC-Teiler gelöst werden.

Der Erfindung liegt die Aufgabe zugrunde, einen Spannungsteiler zu schaffen, bei dem die Schwachstelle a) weitgehend eliminiert ist und der demzufolge wesentlich genauer die Primärspannung in eine Sekundärspannung wandelt als vergleichbare bekannte Spannungsteiler.

Diese Aufgabe wird durch den erfindungsgemässen Spannungsteiler gelöst, wie er im unabhängigen Patentanspruch 1 definiert ist. Bevorzugte Ausführungsvarianten, die auch die Schwachstellen b), d) und e) weitgehend eliminieren, ergeben sich aus den abhängigen Patentansprüchen.

Das Wesen der Erfindung besteht darin, dass bei einem Spannungsteiler für die Messung der Primärspannung $U_p$ zwischen Phase und Erde oder zwischen Phase und Nulleiter in Ein-, Zwei- und Dreiphasensystemen, mit einem mindestens einen Primärwiderstand R aufweisenden Primärteil, einem einen Sekundärwiderstand $R_S$ aufweisenden Sekundärteil und zwei an den Sekundärteil angeschlossenen Messleitungen, der Sekun-. därwiderstand $R_S$ und die beiden Messleitungen so ausgebildet und angeordnet sind, dass sich die durch ein Magnetfeld am Sekundärteil des Spannungsteilers induzierten Spannungen gegenseitig aufheben oder die spannungsinduzierenden Flächen zwischen dem Strompfad des Sekundärwiderstandes $R_S$ und den beiden Messleitungen möglichst klein sind. Es ist ausserdem wesentlich, dass der Spannungsteiler mehrere in Serie geschaltete Primärwiderstände R aufweist, die w-förmig oder spiralförmig angeordnet sind.

Dadurch, dass sich beim erfindungsgemässen Spannungsteiler die am Sekundärteil induzierten Spannungen gegenseitig aufheben oder die spannungsinduzierenden Flächen und somit die induzierten Spannungen möglichst klein sind, wird die Messung der Primärspannung $U_p$ durch diese nicht oder zumindest deutlich weniger verfälscht als bei den bisher bekannten, vergleichbaren Spannungsteilern und ist daher genauer.

Vorzugsweise werden als Widerstände Rund- oder Flach-Dickschichtwiderstände verwendet. Um eine Beschädigung der Widerstandsaktivteile zu vermeiden, können die Rund- oder Flach-Dickschichtwiderstände so ausgebildet werden, dass eine hohe Oberflächenfeldstärke $\vec{E}$ senkrecht zur Widerstandsaktivteilschicht zulässig ist und dass sie eine Eigeninduktivität kleiner 1 nH besitzen.

Durch die Verwendung von Flachwiderständen anstelle von Rundwiderständen und durch geeignetes Anordnen derselben kann ebenfalls das transiente Verhalten des Spannungsteilers deutlich verbessert werden.

Vorzugsweise besitzt jeder Widerstand einen Temperaturkoeffizenten TK, der kleiner oder gleich dem Quotienten zwischen der maximal zulässigen Änderung $\Delta_{TR}$ des Spannungs-Übersetzungsverhältnisses und der maximalen Temperaturdifferenz $\Delta T$ der Widerstände im Spannungsteiler ist.

Darf die Änderung $\Delta_{TR}$ des Spannungs-Übersetzungsverhältnisses nicht grösser als $10^{-4}$ sein, ergibt sich somit für eine Temperaturdifferenz $\Delta T$ im Spannungsteiler von 10 K ein Temperaturkoeffizient

$$TK \leq \frac{\Delta_{TR}}{\Delta_T} = \frac{10^{-4}}{10_K} = 10 \cdot 10^{-6} \frac{1}{K}.$$

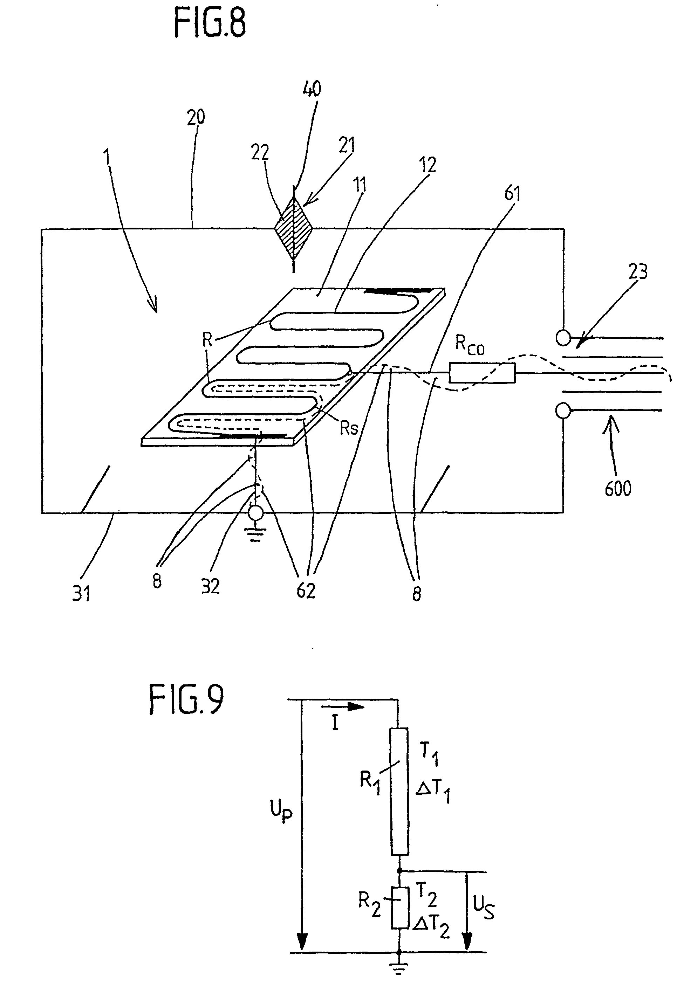

Im folgenden wird diese Beziehung unter Bezugnahme auf Fig. 9 hergeleitet, in der das elektrische Schema eines Spannungsteilers dargestellt ist.

Am Eingang liegt die Primärspannung $U_p$ und am Sekundärwiderstand $R_2$ wird die Sekundärspannung $U_S$ abgegriffen. Im Widerstand $R_1$ wird die Leistung $P_1 = I^2 \cdot R_1$ und im Widerstand $R_2$ die Leistung $P_2 = I^2 \cdot R_2$ umgesetzt. Der Strom I ist durch die Beziehung

$$I = \frac{U_P}{R_1 + R_2} \tag{1}$$

gegeben.

Die Leistung $P_1$ erwärmt den Widerstand $R_1$ um $\Delta T_1 = T_1 - T_0$ und die Leistung $P_2$ erwärmt den Widerstand $R_2$ um $\Delta T_2 = T_2 - T_0$. Die Temperatur $T_0$ ist dabei die Umgebungstemperatur. Sie wird für Berechnungen meistens als $T_0 = 20°C = 293.3$ K angenommen. $T_1$ ist die Temperatur am Widerstand $R_1$ und $T_2$ die Temperatur am Widerstand $R_2$.

Die Sekundärspannung $U_S$ ist durch die Gleichung

$$U_S = \frac{R_2 \, (T_2)}{R_1 \, (T_1) + R_2 \, (T_2)} \cdot U_P \tag{2}$$

gegeben.

Die Ohmwerte $R_1$ und $R_2$ hängen vom eingesetzten Widerstandsmaterial ab. In der Praxis liegt der Temperatureinsatzbereich für den Spannungsteiler zwischen 233.3 K (-40°C) und 353.3 K (80°C). Für den ohmschen Widerstand kann eine lineare Abhängigkeit von der Temperatur angenommen werden, die näherungsweise für alle Widerstandsmaterialien zutrifft.

Für die Widerstände $R_1(T)$ und $R_2(T)$ gelten die Beziehungen (siehe R. Paul, Elektrotechnik, Springer Verlag, 1985, ISBN 3-540-13633-9, Seite 74)

$$R_1(T) = R_1\big|_{20°C} \cdot (1 + TK \cdot \Delta T_1) \tag{3}$$

und

$$R_2(T) = R_2\big|_{20°C} \cdot (1 + TK \cdot \Delta T_2) \tag{4}$$

In den Gleichungen (3) und (4) ist TK der Temperaturkoeffizient des eingesetzten Widerstandsmaterials. Werden die Gleichungen (3) und (4) in Gleichung (2) eingesetzt, so gilt:

$$U_S = \frac{R_{20}(1 + TK \cdot \Delta T_2)}{R_{10}(1 + TK \cdot \Delta T_1) + R_{20}(1 + TK \cdot \Delta T_2)} \cdot U_P \tag{5}$$

mit $R_1(20°C) = R_{10}$ und $R_2(20°C) = R_{20}$.
Aus (5) folgt:

$$\frac{U_P}{U_S} = \ddot{U} = \frac{R_{10}(1 + TK \cdot \Delta T_1)}{R_{20}(1 + TK \cdot \Delta T_2)} + 1 \tag{6}$$

Haben die Widerstände $R_1$ und $R_2$ die gleichen Temperaturen $T_1 = T_2$ beziehungsweise $\Delta T_1 = \Delta T_2$, so vereinfacht sich die Gleichung (6) zu

$$\ddot{U}_0 = \frac{R_{10}}{R_{20}} + 1. \tag{7}$$

Für eine geforderte Genauigkeitsklasse des Messsystems von 0.1 % $\mathrel{\widehat{=}} 10^{-3}$ sollte die Abweichung $\Delta_{TR}$ des Übersetzungsverhältnisses des Teilers in Abhängigkeit der Temperaturen $T_1$ und $T_2$ bzw. $\Delta T_1$ und $\Delta T_2$

$$\Delta_{TR} = \frac{\Delta\ddot{U}}{\ddot{U}_0} = \frac{\ddot{U}(T) - \ddot{U}_0}{\ddot{U}_0} \leq 10^{-4} \tag{8}$$

sein. Es ergibt sich

$$\Delta_{TR} = \frac{\dfrac{R_{10}(1 + TK \cdot \Delta T_1)}{R_{20}(1 + TK \cdot \Delta T_2)} + 1 - \dfrac{R_{10}}{R_{20}} - 1}{\dfrac{R_{10}}{R_{20}} + 1} \leq 10^{-4}$$

$$\Delta_{TR} = \frac{\dfrac{(1 + TK \cdot \Delta T_1)}{(1 + TK \cdot \Delta T_2)} - 1}{1 + \dfrac{R_{20}}{R_{10}}} \leq 10^{-4} \tag{9}$$

Mit $R_{10} \gg R_{20}$ ist $\frac{R_{20}}{R_{10}} \ll 1$, damit folgt aus Gleichung (9):

$$\Delta_{TR} \approx \frac{(1 + TK \cdot \Delta T_1)}{(1 + TK \cdot \Delta T_2)} - 1 = \frac{1 + TK \cdot \Delta T_1 - 1 - TK \cdot \Delta T_2}{1 + TK \cdot \Delta T_2}$$

$$\approx \frac{TK\,(\Delta T_1 - \Delta T_2)}{1 + TK \cdot \Delta T_2} \le 10^{-4} \tag{10}$$

Mit

$$\Delta T_1 - \Delta T_2 = T_1 - T_0 - T_2 + T_0 = \Delta T \tag{11}$$

ergibt sich

$$\Delta_{TR} \approx \frac{TK \cdot \Delta T}{1 + TK \cdot \Delta T_2} \tag{12}$$

Da die Temperaturkoeffizienten TK von Widerstandsmaterialien in der Grössenordnung von $10^{-5}$ liegen und die Temperaturerhöhung $\Delta T_2 \le 50°C$ ist, ist in der Gleichung (12) das Produkt $\Delta T_2 \cdot TK \ll 1$ und aus Gleichung (12) folgt:

$$TR = \frac{\Delta \ddot{U}}{\ddot{U}_0} \approx TK \cdot \Delta T \le 10^{-4} \tag{13}$$

Aus Gleichung (13) folgt für eine Temperaturdifferenz von $\Delta T = T_1 - T_2 = 10\,K = 10°C$ an den Widerständen $R_1$ und $R_2$ ein maximaler Temperaturkoeffizent

$$TK \approx \frac{\Delta_{TR}}{\Delta T} \le \frac{10^{-4}}{10\,K} = 10 \cdot 10^{-6}\,\frac{1}{K}\,.$$

Im folgenden wird der erfindungsgemässe Spannungsteiler unter Bezugnahme auf die beigefügten Zeichnungen und anhand von zwei Ausführungsbeispielen detaillierter beschrieben. Es zeigen:

Fig. 2 -    einen als Röhrenshunt ausgebildeten Sekundärwiderstand $R_S$ eines erfindungsgemässen Spannungsteilers;

Fig. 3 -    einen Flachwiderstand eines erfindungsgemässen Spannungsteilers;

Fig. 4 -    schematisch ein erstes Ausführungsbeispiel des erfindungsgemässen Spannungsteilers mit w-förmig angeordneten Flachwiderständen;

Fig. 5 -    eine schematische Schnittansicht des ersten Ausführungsbeispiels gemäss der Linie I-I in Fig. 4;

Fig. 6 -    schematisch ein zweites Ausführungsbeispiel des erfindungsgemässen Spannungsteilers mit spiralförmig angeordneten Flachwiderständen;

Fig. 7 -    eine schematische Schnittansicht des zweiten Ausführungsbeispiels gemäss der Linie II-II in Fig. 6;

Fig. 8 -    schematisch eine Anschlusskonstruktion für die Messung der Sekundärspannung $U_S$ und

Fig. 9 -    das elektrische Schema eines Spannungsteilers.

<u>Figur 2</u>

Ein Sekundärwiderstand $R_S$ eines erfindungsgemässen Spannungsteilers ist hier als Röhrenshunt, auch koaxialer Sekundärteiler genannt, ausgebildet. Der Sekundärwiderstand $R_S$ umfasst ein Keramikrohr 110 als Träger und darauf angeordnet zwei, vier oder sechs symmetrische Dickschichtwiderstandsbahnen. Im Innern des Keramikrohrs 110 ist eine am oberen Ende an die Dickschichtwiderstandsbahnen angeschlossene Messleitung 610 zur Abnahme der Sekundärspannung $U_S(t)$ geführt. Am unteren Ende ist eine weitere Messleitung 620 an die Dickschichtwiderstandsbahnen angeschlossen. Die beiden Messleitungen 610 und 620 sind ausserhalb des Keramikrohrs 110 miteinander verdrillt.

Figur 3

Ein für die Verwendung in einem erfindungsgemässen Spannungsteiler geeigneter niederinduktiver Flachwiderstand 1 umfasst als Träger eine dünne, breite Keramikplatte 11, auf der ein Dickschichtwiderstandsaktivteil 12 mäanderartig angeordnet ist. Der Anschluss des Flachwiderstands 1 erfolgt über Anschlussleitungen 13.

Die Keramikplatte 11 hat eine Länge 1 = 50 mm, eine Breite b = 20 mm und eine Dicke $\delta$ = 1,5 mm. Die Dicke des Dickschichtwiderstandsaktivteils 12 ist hier beispielsweise 15 um. Die bevorzugten Dimensionen können sich je nach der zu messenden Spannung, dem Spannungsteilerstrom und den Prüfwerten ändern. Mit Vorteil ist die Dicke $\delta$ der Keramikplatte 11 kleiner oder gleich 5 mm, insbesondere zwischen 1 und 2 mm, und die Dicke des Dickschichtwiderstandsaktivteils 12 zwischen 5 und 20 $\mu$m.

Für die gesamte weitere Beschreibung gilt folgende Festlegung. Sind in einer Figur zum Zweck zeichnerischer Eindeutigkeit Bezugszeichen enthalten, aber im unmittelbar zugehörigen Beschreibungstext nicht erläutert, so wird auf deren Erwähnung in vorangehenden Figurenbeschreibungen Bezug genommen.

Figuren 4 und 5

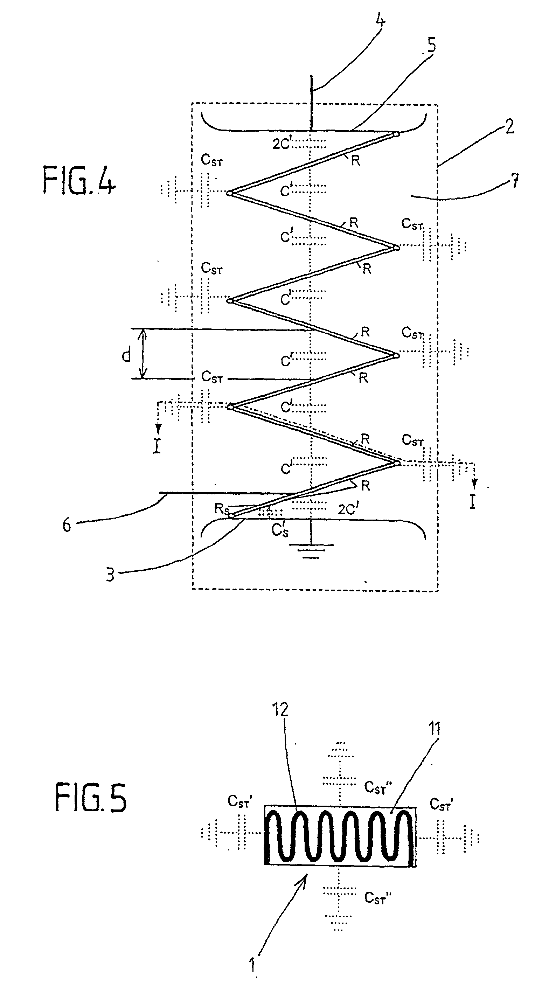

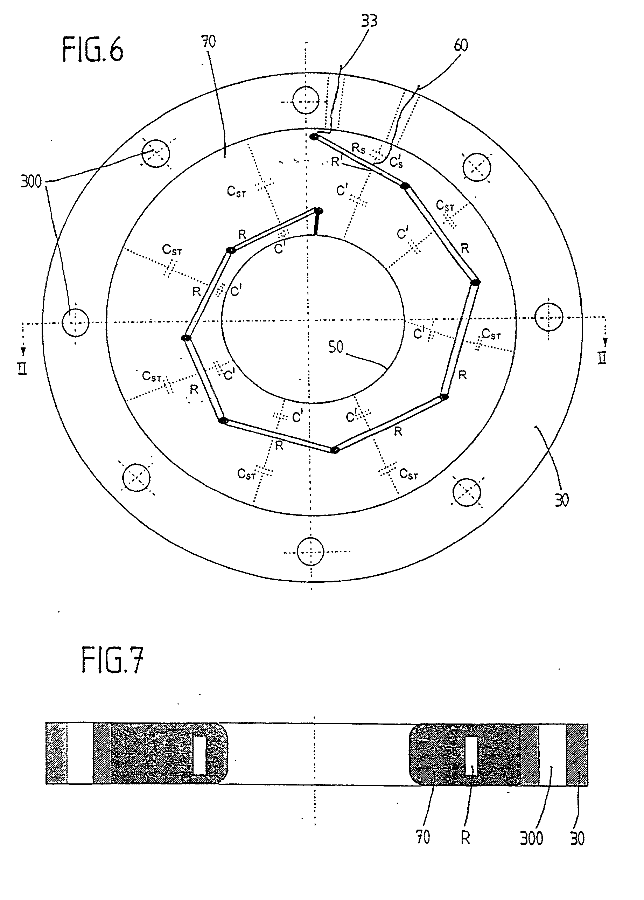

Die Fig. 4 und 5 zeigen den Aufbau eines ersten Ausführungsbeispiels eines Hochspannungs-Spannungsteilers für die Spannungsmessung in Ein-, Zwei- und Dreiphasensystemen. Der Spannungsteiler ist mittels einer Primärspannungs-Anschlussleitung 4, einer Hochspannungselektrode 5 und einer Erdelektrode 3 zwischen einer Phase und Erde angeschlossen. Er umfasst sieben w-förmig angeordnete Primärwiderstände R in Form von Flachwiderständen, wobei ein Teil des untersten Primärwiderstands R zugleich den Sekundärwiderstand $R_S$ bildet. Der mittlere Abstand d zwischen zwei Primärwiderständen R beträgt beispielsweise 15 mm. Zur Messung der Sekundärspannung $U_S$ ist ein Messkabel 6 mit zwei Messleitungen vorgesehen.

Zwischen benachbarten Primärwiderständen R und zwischen der Erde und den Primärwiderständen R ergeben sich natürliche Längsersatzkapazitäten C' bzw. Streuersatzkapazitäten $C_{ST}$. Die Streuersatzkapazitäten sind in Fig. 5 im Vergleich zu Fig. 4 anders verteilt dargestellt und mit $C_{ST}'$ und $C_{ST}''$ bezeichnet. Zwischen der Erde und dem Sekundärwiderstand $R_S$ ergibt sich eine natürliche Sekundärersatzkapazität $C_S'$.

Der Spannungsteiler weist ein metallisches Gehäuse 2 auf, das mit einem Isoliermedium 7, wie z.B. einem Isolieröl, Isolierharz oder Isoliergas (Luft, $SF_6$) gefüllt ist. Als Alternative können die einzelnen Teile auch mit Isolierharz, z.B. Polyurethan oder Epoxydharz, umhüllt sein. Der vergossene oder mit einem Isoliermedium gefüllte Spannungsteiler muss teilentladungsfrei sein, d.h. es dürfen keine Koronaentladungen auftreten.

Die Grösse der Längsersatzkapazitäten C' hängt von der Fläche und dem mittleren Abstand d der Primärwiderstände R und der relativen Permittivität $\varepsilon_r$ des Isoliermediums ab. Vorteilhafterweise ist die relative Permittivität $\varepsilon_R$ grösser oder gleich 4. Die Streuersatzkapazitäten $C_{ST}$, $C_{ST}'$ und $C_{ST}''$ werden entscheidend durch die zur Erde wirksame Fläche der Primärwiderstände R bestimmt.

Die grössten mechanischen Kräfte ($\sim \frac{U^2}{2} C_{ST}'$ bzw. $\sim \frac{U^2}{2} C_{ST}''$) an der Dickschichtwiderstandsbahn treten beim obersten Widerstand auf und werden durch die Spannung und Kapazitäten $C_{ST}'$ bzw. $C_{ST}''$ zwischen Widerstand und metallischem Gehäuse bestimmt.

Die Kräfte

$$(\sim \frac{1}{2}\left(\frac{U}{7}\right)^2 \cdot C'')$$

zwischen den Widerständen sind vernachlässigbar.

Figuren 6 und 7

Bei diesem zweiten Ausführungsbeispiel eines erfindungsgemässen Spannungsteilers sind die Primärwiderstände R in Form von Flachwiderständen zwischen einer Hochspannungselektrode 50 und einer Erdleitung 33 angeschlossen und spiralförmig um die Hochspannungselektrode 50 herum angeordnet. Ein Teil des äussersten Primärwiderstands R bildet zugleich den Sekundärwiderstand $R_S$. Zur Messung der Sekundärspannung $U_S$ ist ein Messkabel 60 mit zwei Messleitungen vorgesehen.

Zwischen den Primärwiderständen R und der Hochspannungselektrode 50 und zwischen einer durch einen Flansch 30 gebildeten Erdelektrode und den Primärwiderständen R ergeben sich natürliche Längsersatzkapazitäten C' bzw. Streuersatzkapazitäten $C_{ST}$. Zwischen der Erde und dem Sekundärwiderstand $R_S$ ergibt sich eine natürliche Sekundärersatzkapazität $C_S'$.

Durch die spiralförmige Anordnung der Primärwiderstände R sind die Längsersatzkapazitäten C' am Anfang, wo sich die Primärwiderstände R nahe bei der Hochspannungselektrode 50 befinden, wesentlich grösser als die dazugehörige Streuersatzkapazität $C_{ST}$. Bei dieser Ausführung werden die mechanischen Kräfte an der Dickschichtwiderstandsbahn bestimmt durch die Kapazitäten C' und $C_{ST}$ und die dazugehörige Spannung.

Die einzelnen Teile können wie beim ersten Ausführungsbeispiel in einem Isoliermedium 70 eingebettet sein. Als sehr zweckmässig hat sich das Eingiessen in Isolierharz herausgestellt.

Zur Erleichterung der Montage des Spannungsteilers ist der Flansch 30 mit Schraubenlöchern 300 versehen.

Der Frequenzgang der Spannungsteiler gemäss dem ersten und dem zweiten Ausführungsbeispiel kann durch Parallelschaltung einer Zusatzkapazität zu mindestens einem Primärwiderstand R erweitert werden, was bei Spannungsteilern für Primärspannungen $U_p \geq 72$ kV aus Gründen einer gleichmässigen Spannungsverteilung häufig erforderlich ist.

In den Spannungsteilern gemäss dem ersten und dem zweiten Ausführungsbeispiel treten bei Schaltvorgängen und Kurzschlüssen dynamische Feldkräfte auf. Die dynamischen Feldkräfte zwischen den Widerständen dürfen nicht zur Beschädigung der Widerstände durch Herausreissen einzelner Widerstandspartikel aus den Dickschichtwiderstandsaktivteilen 12 führen, da dies zu einer Widerstandsänderung führen könnte. Eine Umhüllung der Widerstände mit Glas, das bei hoher Temperatur aufgebracht wird, gewährt einen Schutz gegen Feldkräfte.

Ein weiterer Faktor, der zur Änderung des Widerstandes führen kann, sind plötzliche Veränderungen der zu messenden Spannung durch Schaltvorgänge, insbesondere mit Vakuumschaltern, die beim Öffnen zu Rückzündungen neigen und scharfe Spannungsänderungen zur Folge haben. Eine gezielte Voralterung der Widerstände durch Beanspruchung mit einer definierten Spannungsänderung garantiert hochstabile Widerstandswerte.

Figur 8

Der Einsatz von Spannungsteilern mit kleinen Ausgangssignalen von beispielsweise $\pm$ 3,25 V und einem angeschlossenen Verbraucher mit einer Leistung im mW-Bereich, was einem sehr hochohmigen Messkreis entspricht, erfordert

a) eine spezielle Leitungsführung gegen Einkopplung von durch Magnetfelder verursachten Störungen und

b) ein doppelt abgeschirmtes Anschlusskabel gegen die Einkopplung von durch quasistationäre Felder verursachten Störungen (kapazitive Kopplung),

um die elektromagnetische Verträglichkeit sicherzustellen.

Die dargestellte Anschlusskonstruktion für die Messung der Sekundärspannung $U_S$ verhindert magnetische und kapazitive Einkopplungen weitgehend.

Die kapazitive Einkopplung von Störungen wird durch eine weitgehend geschlossene, metallische Abschirmung 20 verhindert. Die Abschirmung 20 weist eine mit Epoxydharz 22 gefüllte Durchführung 21 für eine Primärspannungs-Anschlussleitung 40 sowie eine Durchführung 23 für ein doppelt abgeschirmtes Messkabel 600 mit einer ersten Messleitung 61, einer zweiten Messleitung 62 und einem Eingangswiderstand $R_{CO}$ auf. Der Eingangswiderstand $R_{CO}$ dient dazu, für hohe Frequenzen das richtige Übertragungsverhalten sicherzustellen.

Eine Einkopplung von durch magnetische Felder verursachten Störungen (induktive Koppludg), wird durch eine gezielte Leitungsführung, insbesondere Verdrillung, stark reduziert. Am einen Ende des Sekundärwiderstands $R_S$, der durch einen Teil des Primärwiderstands R gebildet ist, ist an einer Anzapfstelle die Messleitung 61 angeschlossen. Die zweite Messleitung 62 ist bis zu diesem Anschluss mit der ersten Messleitung 61 verdrillt, verläuft von dort bis zum anderen Ende des Sekundärwiderstands $R_S$ parallel zum Dickschichtwiderstandsaktivteil 12 und ist von dort an mit einer den Sekundärwiderstand $R_S$ erdenden Erdleitung 32 verdrillt und über eine Erdelektrode 31 an die Erde gelegt.

Die existierenden Restflächen 8 zwischen den Leitungen im sekundären Messsystem bestimmen die induzierte Störspannung

$$U_{stör} = \int_A \frac{dB}{dt} \, dA \; .$$

B ist die durch die störenden Magnetfelder der Wechselströme der Hochspannungsanlage hervorgerufene Flussdichte, A die Gesamtfläche der Restflächen 8.

Zu den vorbeschriebenen Spannungsteilern sind weitere konstruktive Variationen realisierbar. Hier ausdrücklich erwähnt sei noch, dass das sekundäre Messsystem bei den Spannungsteilern gemäss den Fig. 4 und 6 auch als Röhrenshuntsystem gemäss Fig. 2 ausgebildet sein kann.

**Patentansprüche**

1. Spannungsteiler für die Messung der Primärspannung $U_p$ zwischen Phase und Erde oder zwischen Phase und Nulleiter in Ein-, Zwei- und Dreiphasensystemen, mit einem mindestens einen Primärwiderstand R aufweisenden Primärteil, einem einen Sekundärwiderstand $R_S$ aufweisenden Sekundärteil und zwei an den Sekundärteil angeschlossenen Messleitungen (61,62;610,620), dadurch gekennzeichnet, dass der Sekundärwiderstand $R_S$ und die beiden Messleitungen (61,62;610,620) so ausgebildet und angeordnet sind, dass sich die durch ein Magnetfeld am Sekundärteil des Spannungsteilers induzierten Spannungen gegenseitig aufheben oder die spannungsinduzierenden Flächen zwischen dem Strompfad des Sekundärwiderstands $R_S$ und den beiden Messleitungen (61,62: 610,620) möglichst klein sind, und dadurch, dass der Spannungsteiler mehrere in Serie geschaltete Primärwiderstände R aufweist, die w-förmig oder spiralförmig angeordnet sind.

2. Spannungsteiler nach Anspruch 1, dadurch gekennzeichnet, dass der Primärteil mindestens eine zu einem Primärwiderstand R parallelgeschaltete Längskapazität C oder parallele natürliche Längsersatzkapazität C' und der Sekundärteil eine zum Sekundärwiderstand $R_S$ parallelgeschaltete Sekundärkapazität $C_S$ oder parallele natürliche Sekundärersatzkapazität $C_S$' aufweist und der Sekundärwiderstand $R_S$ ein Teil eines Primärwiderstands R sein kann.

3. Spannungsteiler nach Anspruch 1 oder 2, dadurch gekennzeichnet, dass jeder Widerstand ein Dickschichtwiderstandsaktivteil (12) aufweist und von einer Glasschicht umgeben ist, die ein Herausreissen von Widerstandspartikeln aus dem Dickschichtwiderstandsaktivteil (12) durch elektrische Feldkräfte verunmöglicht.

4. Spannungsteiler nach einem der Ansprüche 1 bis 3, dadurch gekennzeichnet, dass jeder Widerstand ein Flachwiderstand (1) ist, der eine Keramikplatte (11) mit einer Dicke δ grösser oder gleich 1 mm, insbesondere zwischen 1,5 und 2 mm, umfasst, auf der ein Dickschichtwiderstandsaktivteil (12) mit einer Dicke grösser oder gleich 8 μm, insbesondere grösser oder gleich 12 μm, mäanderartig angeordnet ist.

5. Spannungsteiler nach einem der Ansprüche 1 bis 4, dadurch gekennzeichnet, dass jeder Widerstand eine Eigeninduktivität kleiner 1 nH aufweist und durch Spannungsimpulse mit einer hohen Steilheit vorgealtert ist.

6. Spannungsteiler nach einem der Ansprüche 1 bis 5, dadurch gekennzeichnet, dass jeder Widerstand einen Temperaturkoeffizienten TK besitzt, der kleiner oder gleich dem Quotienten zwischen der maximal zulässigen Änderung $\Delta_{TR}$ des Spannungs-Übersetzungsverhältnisses und der maximalen Temperaturdifferenz $\Delta T$ der Widerstände im Spannungsteiler ist.

7. Spannungsteiler nach einem der Ansprüche 1 bis 6, dadurch gekennzeichnet, dass der Primärteil mindestens eine natürliche Längsersatzkapazität C' aufweist, zu der eine Zusatzkapazität parallelgeschaltet ist, wobei die Zusatzkapazität bzw. -kapazitäten so gewählt ist bzw. sind, dass eine gewünschte Spannungs-Übergangs- oder Übertragungsfunktion besteht.

8. Spannungsteiler nach einem der Ansprüche 1 bis 7, dadurch gekennzeichnet, dass die erste (61) der beiden Messleitungen am einen Ende des Sekundärwiderstands $R_S$ angeschlossen ist und die zweite Messleitung (62) bis zu , diesem Anschluss mit der ersten Messleitung (61) verdrillt ist, von dort bis zum anderen Ende des Sekundärwiderstands $R_S$ parallel zum Strompfad des Sekundärwiderstands $R_S$ verläuft und von dort an mit einer den Sekundärwiderstand $R_S$ erdenden Erdleitung (32) verdrillt und an die Erde gelegt ist.

9. Spannungsteiler nach einem der Ansprüche 1 bis 8, dadurch gekennzeichnet, dass der Sekundärwiderstand $R_S$ die Form eines Röhrenshunts aufweist, bei dem der Dickschichtoder Schichtwiderstand auf einem Keramikrohr (110) angeordnet ist und eine der beiden Messleitungen (610,620) für die Messung der Sekundärspannung $U_s$ im Innern des Keramikrohrs (110) verläuft.

## Claims

1. Voltage divider for measurement of the primary voltage Up between phase and earth or between phase and the neutral conductor in single-phase, two-phase and three-phase systems, having a primary part which has at least one primary resistor R, having a secondary part which has a secondary resistor $R_S$, and having two measurement lines (61, 62; 610, 620) which are connected to the secondary part, characterized in that the secondary resistor $R_S$ and the two measurement lines (61, 62; 610, 620) are designed and arranged such that the voltages induced by a magnetic field on the secondary part of the voltage divider cancel one another out or the voltage-inducing areas between the current path of the secondary resistor $R_S$ and the two measurement lines (61, 62; 610, 620) are as small as possible, and in that the voltage divider has a number of series-connected primary resistors R which are arranged in a w-shape or spiral shape.

2. Voltage divider according to Claim 1, characterized in that the primary part has at least one series capacitance C connected in parallel with a primary resistor R or a natural series equivalent capacitance C' in parallel with a primary resistor R, and the secondary part has a secondary capacitor $C_S$ connected in parallel with the secondary resistor $R_S$ or a natural secondary equivalent capacitance $C_S$' in parallel with the secondary resistor $R_S$ and the secondary resistor $R_S$ may be a part of a primary resistor R.

3. Voltage divider according to Claim 1 or 2, characterized in that each resistor has a thick-film resistor active part (12) and is surrounded by a glass layer which makes it impossible for resistor particles to be torn out of the thick-film resistor active part (12) by electrical field forces.

4. Voltage divider according to one of Claims 1 to 3, characterized in that each resistor is a surface resistor (1) which comprises a ceramic plate (11) with a thickness $\delta$ of not less than 1 mm, in particular between 1.5 and 2 mm, on which a thick-film resistor active part (12) having a thickness of not less than 8 $\mu$m, in particular of not less than 12 $\mu$m, is arranged in a meandering shape.

5. Voltage divider according to one of Claims 1 to 4, characterized in that each resistor has an intrinsic inductance of less than 1 nH, and is preaged by voltage pulses having a steep gradient.

6. Voltage divider according to one of Claims 1 to 5, characterized in that each resistor has a temperature coefficient TK which is not more than the quotient between the maximum permissible change $\Delta_{TR}$ of the voltage transformation ratio and the maximum temperature difference $\Delta$T of the resistors in the voltage divider.

7. Voltage divider according to one of Claims 1 to 6, characterized in that the primary part has at least one natural series equivalent capacitance C', in parallel with which an additional capacitance is connected, with the additional capacitance or capacitances being selected such that a desired voltage transfer function or transmission function is produced.

8. Voltage divider according to one of Claims 1 to 7, characterized in that the first (61) of the two measurement lines is connected to one end of the secondary resistor $R_S$, and the secondary measurement line (62) is twisted with the first measurement line (61) as far as this connection, from where and as far as the other end of the secondary resistor $R_S$ it runs parallel to the current path of the secondary resistor $R_S$, from where it is twisted with an earth line (32) which earths the secondary resistor $R_S$, and is connected to earth.

9. Voltage divider according to one of Claims 1 to 8, characterized in that the secondary resistor $R_S$ is in the form of a tubular shunt, in which the thick-film or film resistor is arranged on a ceramic tube (110), and one of the two measurement lines (610, 620) for measurement of the secondary voltage $U_S$ runs in the interior of the ceramic tube (110).

## Revendications

1. Diviseur de tension pour la mesure de la tension primaire $U_p$ entre la phase et la terre ou entre la phase et le neutre dans des systèmes mono-, bi- et triphasés, avec une partie primaire présentant au moins une résistance primaire R, une partie secondaire présentant une résistance secondaire $R_S$ et deux lignes de mesure (61, 62 ; 610, 620) raccordées à la partie secondaire, caractérisé en ce que la résistance secondaire $R_S$ et les deux lignes de mesure (61, 62 ; 610, 620) sont formées et disposées de telle manière que les tensions induites par un champ magnétique sur la partie secondaire du diviseur de tension s'annulent mutuellement ou les surfaces induisant une tension entre le chemin du courant de la résistance secondaire $R_S$ et les deux lignes de mesure (61, 62 ; 610, 620) sont les plus petites possible, et en ce que le diviseur de tension présente plusieurs résistances primaires R branchées en série qui sont disposées en forme de w ou de spirale.

2. Diviseur de tension selon la revendication 1, caractérisé en ce que la partie primaire présente au moins une capacité série C branchée en parallèle avec une résistance primaire R ou une capacité équivalente série naturelle C' en parallèle avec une résistance primaire R et la partie secondaire présente une capacité secondaire $C_S$ branchée en parallèle avec la résistance secondaire $R_S$ ou une capacité équivalente secondaire naturelle $C_S'$ en parallèle avec la résistance secondaire $R_S$ et la résistance secondaire $R_S$ peut être une partie d'une résistance primaire R.

3. Diviseur de tension selon la revendication 1 ou 2, caractérisé en ce que chaque résistance présente une partie active de résistance à couche épaisse (12) et est entourée par une couche en verre qui rend impossible l'arrachage de particules de résistance de la partie active de résistance à couche épaisse (12) par des champs électriques.

4. Diviseur de tension selon l'une des revendications 1 à 3, caractérisé en ce que chaque résistance est une résistance plate (1) qui comprend une plaquette en céramique (11) ayant une épaisseur δ supérieure ou égale à 1 mm, notamment comprise entre 1,5 et 2 mm, sur laquelle est disposée à la manière de méandres une partie active de résistance à couche épaisse (12) ayant une épaisseur supérieure ou égale à 8 μm, notamment supérieure ou égale à 12 μm.

5. Diviseur de tension selon l'une des revendications 1 à 4, caractérisé en ce que chaque résistance présente une inductance propre inférieure à 1 nH et qu'elle est vieillie prématurément par des impulsions de tension à pente très raide.

6. Diviseur de tension selon l'une des revendications 1 à 5, caractérisé en ce que chaque résistance possède un coefficient de température TK qui est inférieur ou égal au quotient entre la variation $\Delta_{TR}$ maximale admissible du rapport de conversion de tension 'et la différence de température maximale $\Delta T$ des résistances dans le diviseur de tension.

7. Diviseur de tension selon l'une des revendications 1 à 6, caractérisé en ce que la partie primaire présente au moins une capacité équivalente série naturelle C' en parallèle de laquelle est branchée une capacité supplémentaire, la ou les capacités supplémentaires étant choisies de manière à obtenir une fonction souhaitée de transfert ou de transmission de la tension.

8. Diviseur de tension selon l'une des revendications 1 à 7, caractérisé en ce que la première (61) des deux lignes de mesure est raccordée à une extrémité de la résistance secondaire $R_S$ et la deuxième ligne de mesure (62) est torsadée avec la première ligne de mesure (61) jusqu'à ce point de raccordement, de là s'étend jusqu'à l'autre extrémité de la résistance secondaire $R_S$ en parallèle avec le chemin de courant de la résistance secondaire $R_S$ et de là est torsadée avec une ligne de terre (32) qui relie la résistance secondaire $R_S$ à la terre puis est mise à la terre.

9. Diviseur de tension selon l'une des revendications 1 à 8, caractérisé en ce que la résistance secondaire $R_S$ présente la forme d'un shunt tubulaire sur lequel la résistance à couche épaisse ou la résistance à couche est disposée sur un tube en céramique (110) et l'une des deux lignes de mesure (610, 620) pour la mesure de la tension secondaire $U_S$ passe à l'intérieur du tube en céramique (110).

FIG.1

FIG.2

FIG.3

FIG.4

FIG.5

FIG.6

FIG.7

## FIG.8

## FIG.9